# EUROPEAN PATENT SPECIFICATION

(11) **EP 3 770 983 B1**
(45) Date of publication and mention of the grant of the patent: **15.04.2026**
(21) Application number: 19188608.4
(22) Date of filing: 26.07.2019
(51) Int. Cl.: H10K 30/82

(54) **TRANSPARENT CONDUCTIVE ELECTRODE AND METHOD FOR MANUFACTURING THE SAME**
TRANSPARENTE LEITFÄHIGE ELEKTRODE UND VERFAHREN ZUR HERSTELLUNG DAVON
ÉLECTRODE CONDUCTEUR TRANSPARENT ET SON PROCÉDÉ DE FABRICATION

(43) Date of publication of application: 27.01.2021
(73) Proprietor: AIT Austrian Institute of Technology GmbH, 1210 Wien (AT)
(72) Inventor: DIMOPOULOS, Theodoros, 3423 St. Andrä-Wördern (AT); BAUCH, Martin, 1020 Wien (AT); ABERMANN, Stephan, 1060 Wien (AT)
(74) Representative: Pföstl, Andreas

(56) References cited:
- EP-A1- 1 796 107
- YANG XU ET AL: "Efficient Semitransparent Inverted Polymer Solar Cells With the Anode of Tunable Incident Light Transmittance", IEEE ELECTRON DEVICE LETTERS, IEEE SERVICE CENTER, NEW YORK, NY, US, vol. 33, no. 7, 8 June 2012 (2012-06-08) - 1 July 2012 (2012-07-01), pages 1027 - 1029, XP011448523, ISSN: 0741-3106, DOI: 10.1109/LED.2012.2196971
- LIANG SHEN ET AL: "Semitransparent inverted polymer solar cells using MoO/Ag/VOas transparent anodes", SOLAR ENERGY MATERIALS AND SOLAR CELLS, vol. 97, 1 October 2011 (2011-10-01), pages 59 - 63, XP028338994, ISSN: 0927-0248, [retrieved on 20110917], DOI: 10.1016/J.SOLMAT.2011.09.004
- ZHAO ZHAO ET AL: "The optimal TiO2/Ag/TiO2electrode for organic solar cell application with high device-specific Haacke figure of merit", SOLAR ENERGY MATERIALS AND SOLAR CELLS, ELSEVIER SCIENCE PUBLISHERS, AMSTERDAM, NL, vol. 157, 3 August 2016 (2016-08-03), pages 599 - 603, XP029730745, ISSN: 0927-0248, DOI: 10.1016/J.SOLMAT.2016.07.044

## Description

The present disclosure concerns a transparent conductive electrode comprising a first dielectric layer, a second dielectric layer, and a metal layer sandwiched between the first and the second dielectric layer.

Transparent Metal/Dielectric (MD) and Dielectric/Metal/Dielectric (DMD) electrodes are used in all kinds of optoelectronic devices, e.g. solar cells, light-emitting diodes (LEDs) or optical sensors, since they allow to achieve a low sheet resistance while being sufficiently transparent. US 9,419,174 B2 discloses a DMD electrode to be applied in LED devices.

The dielectric layers of MD and DMD electrodes are usually composed substantially of oxide compounds based on elements selected from the group consisting of indium (In), tantalum (Ta), niobium (Nb), titanium (Ti), hafnium (Hf), tungsten (W) zirconium (Zr), zinc (Zn) and silicon (Si). Molybdenum (Mo) oxide thin films are also highly interesting for optoelectronic and other applications, as they have favourable chemical, electronic and optical properties.

The problem is that molybdenum oxide (MoOₓ) thin films, which are in general composed of a mixture of Mo⁴⁺, Mo⁵⁺ and Mo⁶⁺ oxidation states, are unstable to water, if in the MoOₓ thin film x≈3, or x is close to 3. Thus, the MoOₓ thin films degrade or even dissolve when they get in contact with water.

MoOₓ films are widely used in optoelectronic devices and solar cells. Their instability in water compromises their functionality in these devices and hampers their processing with substances containing water as solvent, such as the commonly used organic semiconductor PEDOT:PSS (Poly(3,4-ethylenedioxythiophene:Polystyrene-Sulfonate), commonly purchased as water-based solution.

The EP 1796 107 A1 discloses transparent conductors having transparency and conductivity which are capable of being stably supplied and which comprise a metal oxide M:TiO₂ having an anatase type crystal structure. M can be Nb, Ta, Mo, As, Sb or W.

The objective of the invention is to provide MD and DMD electrodes comprising MoOₓ-based thin films with enhanced chemical stability, particularly with respect to water, while retaining their favourable chemical, electronic and optical properties.

According to the invention, here is provided a transparent conductive electrode according to claim 1.

More precisely, the present invention relates to a transparent conductive metal/dielectric electrode comprising a second dielectric layer atop a metal layer wherein the second dielectric layer is a molybdenum-titanium-oxide, a molybdenum-tantalum-oxide or a molybdenum-titanium-tantalum-oxide compound, respectively.

Furthermore, the present invention relates to a transparent conductive dielectric/metal/dielectric electrode comprising a first dielectric layer, the second dielectric layer, and the metal layer sandwiched between the first and the second dielectric layer, wherein the second and optionally also the first dielectric layer/s is/ are molybdenum-titanium-oxide, molybdenum-tantalum-oxide and/ or molybdenum-titanium-tantalum-oxide compound/s, respectively.

According to the present invention, a molybdenum-titanium-oxide comprises molybdenum oxide and titanium oxide preferably having formula MoOₓ-TiO_{y}, more preferably MoOₓ-TiO₂, more preferably MoO₃-TiO₂. Accordingly, a molybdenum-tantalum-oxide comprises molybdenum oxide and tantalum oxide preferably having formula MoOₓ-Ta_{z}Oₖ, more preferably MoOₓ-Ta₂O₅, more preferably MoO₃-Ta₂O₅. Accordingly, a molybdenum-titanium-tantalum-oxide comprises molybdenum oxide, titanium oxide and tantalum oxide, preferably having formula MoOₓ-TiO_{y}-Ta_{z}Oₖ, more preferably MoOₓ-TiO₂-Ta₂O₅, more preferably MoO₃-TiO₂-Ta₂O₅. Here, "x" is preferably a number between 2 and 3, more preferably between 2.5 and 3, or about 3. "y" is preferably a number between 1 and 2, more preferably between 1.5 and 2, or about 2. "z" is preferably a number between 1 and 2, more preferably between 1.5 and 2, or about 2. "k" is preferably a number between 4 and 5, more preferably between 4.5 and 5, or about 5.

The individual oxide components, e.g. MoOₓ, TiO_{y}, Ta_{z}Oₖ, in these compounds are present in such ratio, so that the atomic concentration ratio between molybdenum and titanium (Mo:Ti), molybdenum and tantalum (Mo:Ta), and/or molybdenum and the sum of titanium and tantalum (Mo:(Ti+Ta)), respectively, is between 100:1 and 0.5:1, preferably between 20:1 and 2:1.

The term "compound" can also be considered as "composite" or "multinary oxide" as these terms are used as synonyms in the state-of-the-art.

The terms "consists substantially of" and "composed substantially of" in relation to a chemical composition (e.g. a dielectric layer), as defined herein, can be used interchangeably and mean that the composition may be free or contain less than 0.5 wt%, preferably less than 0.1 wt%, contaminants in the form of other atoms. The word "substantially" does not exclude "complete".

The term "molybdenum oxide containing titanium oxide and/or tantalum oxide", as used herein, can be used interchangeable with "molybdenum oxide doped with titanium and/or tantalum" or with "molybdenum oxide containing titanium and/or tantalum".

In a further embodiment of any of the foregoing transparent conductive, in particular dielectric/metal/dielectric, electrodes, the second dielectric layer is atop the metal layer or the metal layer is sandwiched between the first dielectric layer and the second dielectric layer.

In a further embodiment of any of the foregoing transparent conductive, in particular dielectric/metal/dielectric, electrodes, the second dielectric layer and the first dielectric layer comprise molybdenum oxide containing titanium oxide and/ or tantalum oxide, wherein in a preferred embodiment of the present invention the second dielectric layer and the first dielectric layer comprise or consist substantially of molybdenum-titanium-oxide, molybdenum-tantalum-oxide, and/ or molybdenum-titanium-tantalum-oxide compounds, respectively.

In a further embodiment of any of the foregoing transparent conductive, in particular metal/dielectric electrode or dielectric/metal/dielectric, electrodes, the atomic concentration ratio between molybdenum and titanium (Mo:Ti), molybdenum and tantalum (Mo:Ta), and/or molybdenum and the sum of titanium and tantalum (Mo:(Ti+Ta)), respectively, is between 100:1 and 0.5:1, preferably between 20:1 and 2:1.

In a further embodiment of any of the foregoing transparent conductive, in particular metal/dielectric electrodes or dielectric/metal/dielectric, electrodes, the metal layer consists substantially of silver, gold copper, aluminium, nickel or platinum, or alloys of these metals.

In a further embodiment of the foregoing transparent conductive, in particular metal/dielectric electrodes or dielectric/metal/dielectric, electrodes, the metal layer consists substantially of silver, copper, aluminium or nickel, and wherein the second dielectric layer consists substantially of a molybdenum-titanium-oxide, a molybdenum-tantalum-oxide or a molybdenum-titanium-tantalum-oxide, comprising an interfacial layer in contact with the metal layer and a bulk layer, wherein the interfacial layer has a lower oxygen content than the bulk layer.

In a further embodiment of any of the foregoing transparent conductive, in particular metal/dielectric electrodes or dielectric/metal/dielectric, electrodes, the metal layer has a thickness between 3 and 30 nm, preferably between 5 and 20 nm, most preferably between 5 and 15 nm, and/ or wherein the first and/ or the second dielectric layer has/ have a thickness between 5 and 100 nm, preferably between 10 and 70 nm, most preferably between 20 and 50 nm.

A further aspect of the present invention relates to an optoelectronic device comprising a substrate, wherein the optoelectronic device comprises at least one transparent conductive electrode, in particular at least one metal/dielectric electrode or dielectric/metal/dielectric electrode, according to the present invention.

In a further embodiment of the foregoing optoelectronic device, it comprises at least one photoactive layer, particularly a solar cell comprising a light absorbing layer or a light-emitting diode comprising a light emitting layer.

In an embodiment of the present invention the substrate is a polyethylene terephthalate substrate (PET), and wherein the metal layer consists substantially of silver and the optional first and second dielectric layer of the transparent conductive electrode consists substantially of molybdenum-titanium-oxide, molybdenum-tantalum-oxide or molybdenum-titanium-tantalum-oxide.

In a further embodiment of any of the foregoing optoelectronic devices, the substrate is a PET substrate and the metal/dielectric electrode consists substantially of Ag/molybdenum-titanium-oxide or Ag/molybdenum-tantalum-oxide or Ag/molybdenum-titanium-tantalum-oxide or the dielectric/metal/dielectric electrode consists substantially of molybdenum-titanium-oxide/Ag/molybdenum-titanium-oxide or molybdenum-tantalum-oxide/Ag/molybdenum-tantalum-oxide, or molybdenum-titanium-tantalum-oxide/Ag/molybdenum-titanium-tantalum-oxide, respectively.

In a further embodiment of any of the foregoing optoelectronic devices, a polymer interlayer is sandwiched between the first or second dielectric layer and the substrate or between the metal layer and the substrate, respectively.

In a further embodiment of any of the foregoing optoelectronic devices, the light absorbing layer is a perovskite light absorbing layer directly deposited on the transparent conductive electrode.

Another aspect of the present invention relates to a method for depositing a transparent conductive, in particular a metal/dielectric or a dielectric/metal/dielectric, electrode according to the present invention onto a substrate, wherein the method comprises the following steps.
A) Providing a substrate;
B) Optionally depositing a first dielectric layer onto the substrate;
C) Depositing a metal layer onto the substrate; and
D) Depositing a second dielectric layer onto the metal layer,
wherein the second dielectric layer and optionally also the optional first dielectric layer is a molybdenum-titanium-oxide, a molybdenum-tantalum-oxide or a molybdenum-titanium-tantalum-oxide compound.

Also disclosed is a method for depositing a metal/dielectric electrode according to the present invention onto a substrate, wherein the method comprises the following steps.
A) Providing a substrate;
C) Depositing a metal layer onto the substrate; and
D) Depositing a second dielectric layer onto the metal layer.

Also disclosed is a method for depositing a dielectric/metal/dielectric electrode according to the present invention onto the substrate, wherein the method comprises the following steps.
A) Providing the substrate;
B) Depositing a first dielectric layer onto the substrate;
C) Depositing the metal layer onto the first dielectric layer; and
D) Depositing the second dielectric layer onto the metal layer.

In a further embodiment of the foregoing method, the metal layer consists substantially of silver, copper aluminium or nickel, and wherein the method step D) comprises a first sub-step and a second sub-step, wherein during the first sub-step an interfacial layer of the second dielectric layer is non-reactively sputter-deposited from an oxide target and wherein during the second sub-step a bulk layer of the second dielectric layer is reactively sputter-deposited with plasma containing oxygen from an oxide target.

In a further embodiment of any of the foregoing methods, the substrate is a PET substrate, wherein a polymer interlayer is deposited between method step A) and method step B) or C), respectively, wherein in step B) the first dielectric layer is deposited onto the polymer interlayer or wherein in step C) the metal layer is deposited onto the polymer interlayer, respectively.

Various features will become apparent to those skilled in the art from the following detailed description of the disclosed non-limiting embodiment. The drawings that accompany the detailed description can be briefly described as follows:
Figure 1 shows in a schematic way a DMD electrode according to the invention deposited on a substrate.
Figure 2 shows in a schematic way a DMD electrode according to the invention deposited on a substrate.
Figures 3A and 3B show transmittance spectra of DMD (molybdenum-titanium-oxide/Ag/molybdenum-titanium-oxide, in the figure noted as "MTO/Ag/MTO") electrodes according to the second embodiment of the invention deposited on PET or glass-substrate. The subscript after each layer denotes the thickness of the layer in nanometers (nm). For example, Ag₁₄ means 14 nm of Ag. The sheet resistance of the electrodes on glass and PET substrate is 5 Ohms per square (Ω/sq.). The different spectra correspond to different molybdenum-titanium-oxide layer thicknesses.
Figure 4 shows transmittance spectra of DMD (molybdenum-titanium-oxide/Au/molybdenum-titanium-oxide, in the figure noted as "MTO/Au/MTO") electrodes according to the first embodiment of the invention deposited on PET or glass-substrate. The sheet resistance of the electrodes is 10 Ω/sq.
Figure 5 shows cross section and plain view Scanning Electron Microscopy (SEM) images of DMD (molybdenum-titanium-oxide/Ag/molybdenum-titanium-oxide, in the figure noted as "MTO/Ag/MTO") electrodes according to the second embodiment of the invention at the as-deposited state (A) and after immersion in de-ionized (DI) water for 17 hours (B).
Figure 6 shows DMD (molybdenum-titanium-oxide/Ag/molybdenum-titanium-oxide, in the figure noted as "MTO/Ag/MTO") electrodes according to the second embodiment of the invention processed with toluene- (A) and water-based (B) PEDOT: PSS (poly(3,4-ethylenedioxythiophene) polystyrene sulfonate).
Figures 7A and 7B show photographs of a MoOₓ (x≈3) layer on PET and glass after a drop of de-ionized (DI) water was placed on the layer. The water drop led to the dissolving of the MoOₓ layer. Likewise, when a water-based PEDOT:PSS formulation is processed on the MoOₓ layer, the MoOₓ layer also dissolves.

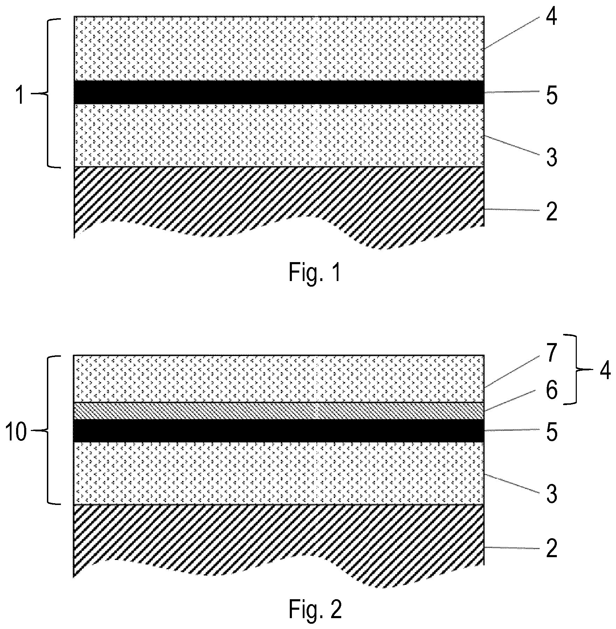

Figure 1 shows a dielectric/metal/dielectric (DMD) electrode 1 according to the invention deposited on a substrate 2. The substrate 2 can be rigid or flexible, for example a glass, polyurethane, polyimide substrate, or a PET substrate. Alternatively, the DMD electrode can be deposited onto an active or passive device or device layer, e.g. solar absorber or light emitter. The transparent conductive DMD electrode 1 comprises a first dielectric layer 3, a second dielectric layer 4, and a metal layer 5 sandwiched between the first dielectric layer 3 and the second dielectric layer 4. The substrate 2 is not a feature of the DMD electrode 1.

Alternatively, according to the invention a metal/dielectric (MD) electrode can be deposited on the substrate 2. In his case, the transparent conductive MD electrode comprises the second dielectric layer 4 atop of the metal layer 5, wherein the metal layer 5 is atop of the substrate 2. The substrate 2 is not a feature of the MD electrode.

Figure 2 shows a dielectric/metal/dielectric (DMD) electrode 10 according to the invention deposited on a substrate 2. The substrate 2 can be rigid or flexible, for example a glass, polyurethane, polyimide substrate, or a PET substrate. In principle, the transparent conductive DMD electrode 10 is very similar to the transparent conductive DMD electrode 1, wherein it comprises a first dielectric layer 3, a second dielectric layer 4, and a metal layer 5 sandwiched between the first dielectric layer 3 and the second dielectric layer 4. In addition, the DMD electrode 10 according to the second embodiment of the invention comprises an interfacial layer 6 in contact with the metal layer 5 and a bulk layer 7, wherein in the interfacial layer 6 the molybdenum has a lower oxidation state than in the bulk layer 7. The substrate 2 is not a feature of the DMD electrode 10.

Alternatively, according to the invention a metal/dielectric (MD) electrode can be deposited on the substrate 2. In his case, the transparent conductive MD electrode comprises the second dielectric layer 4 atop of the metal layer 5, wherein the metal layer 5 is atop of the substrate 2. In addition, the MD electrode may then comprise an interfacial layer 6 in contact with the metal layer 5 and a bulk layer 7, wherein in the interfacial layer 6 the molybdenum has a lower oxidation state than in the bulk layer 7. The substrate 2 is not a feature of the MD electrode.

Thus, the MD electrode or the DMD electrode 10 according to the invention has the advantage that, if in the MD or DMD electrode 10, for example in the metal layer 5, a metal/metals such as Ag and/ or Cu is/ are used, which metal/s is/ are prone to oxidation, during the reactive deposition of the second dielectric layer 4 any partial or complete oxidation of the metal is prohibited. Thus, the MD or DMD electrode 10 according to the second embodiment of the invention keeps its electrical conductivity.

The whole MD or DMD electrodes 1 or 10, or the first dielectric layer 3, the second dielectric layer 4, and/ or the metal layer 5 can be fabricated by reactive or non-reactive sputtering from oxide or metallic targets, or by thermal evaporation. Alternatively, solution-based techniques can be also used, for example, deposition from solutions containing nanoparticles.

A preferable fabrication technique is magnetron sputtering of the first dielectric layer 3 and/ or the second dielectric layer 4 from oxide targets, as the technique offers high deposition rates and homogeneous film quality. In this case, a reactive plasma, for example with a mixed argon (Ar) and oxygen (O₂) content, may be used for the deposition in order to tune the oxygen content in the deposited film.

The interfacial layer 6 of the second dielectric layer 4 is preferably deposited without oxygen in the plasma if sputtering methods are used. Then, the bulk layer 7 is deposited with oxygen in the plasma. The interfacial layer 6 has therefore a lower oxygen content than the bulk layer 7. The interfacial layer 6 has the purpose to protect the metal layer 5 from being oxidized during the deposition the bulk layer 7. Preferably, especially if applied in solar cell devices or LEDs, the interfacial layer 6 is continuous and suitably thin, since Mo oxide layers which have a low oxygen content (with the molybdenum mainly in the Mo⁴⁺ and Mo⁺⁵ oxidation states) have high light absorption. Preferably, the interfacial layer 6 has a thickness of 1-20 nm, most preferably 5-10 nm. The bulk layer 7, preferably deposited with reactive plasma, may have a thickness of 0-100 nm, preferably 10-40 nm.

The second dielectric layer 4 and optionally the first dielectric layer 3 of a MD or DMD electrode according to the invention is/ are composed substantially of molybdenum oxide (MoOₓ) containing titanium oxide and/ or tantalum oxide. Thus, the first dielectric layer 3 or the second dielectric layer 4 is a molybdenum-titanium-oxide or molybdenum-tantalum-oxide compound, or, alternatively formulated, the first dielectric layer 3 or the second dielectric layer 4 is a MoOₓ-TiO_{y} or MoOₓ-Ta_{z}Oₖ compound.

Alternatively, the first dielectric layer 3 and the second dielectric layer 4 of a DMD electrode according to the invention are composed substantially of molybdenum oxide (MoOₓ) containing titanium oxide and/or tantalum oxide, wherein the first dielectric layer 3 and the second dielectric layer 4 are molybdenum-titanium-oxide or molybdenum-tantalum-oxide compounds, respectively, or, alternatively formulated, the first dielectric layer 3 and the second dielectric layer 4 are MoOₓ-TiO_{y} or MoOₓ-Ta_{z}Oₖ compounds, respectively.

Alternatively, the first dielectric layer 3 and/or the second dielectric layer 4 of a MD or DMD electrode according to the invention can be composed substantially of molybdenum oxide (MoOₓ) containing titanium oxide and tantalum oxide, wherein the first dielectric layer 3 and/ or the second dielectric layer 4 is a/ are molybdenum-titanium-tantalum-oxide compound or, alternatively formulated, the first dielectric layer 3 and/ or the second dielectric layer 4 is a/ are MoOₓ-TiO_{y}-Ta_{z}Oₖ.

The first dielectric layer 3 and/ or the second dielectric layer 4 of a MD or DMD electrode according to the invention can have a thickness between 5 and 100 nm, preferably between 10 and 70 nm, most preferably between 20 and 50 nm.

The elemental/atomic ratio/s of Mo to Ti (Mo:Ti) and/or Ta (Mo:Ta) in the first dielectric layer 3 and/ or the second dielectric layer 4 is/ are 100:1 and 0.5:1, preferably between 20:1 and 2:1.

The metal layer 5 of a MD or DMD electrode according to the invention is composed substantially of silver (Ag), gold (Au), copper (Cu), aluminium (Al), nickel (Ni), platinum (Pt), or alloys/ compounds of these metals, wherein these alloys for example can be AgAu, AgCu, AuCu, AgNi, AgAl, AgPt, AuAl, AuNi, AuPt, AlNi, AlPt, NiPt, AgAuCu, AgAuAl, AgAuNi, AgAuPt, AuCuAl, AuCuNi, AuCuPt, CuAlNi, CuAlPt and/ or AlNiPt. Ag, Au, Cu and their alloys have low optical losses. The atomic ratio of these alloys can be, for example, Ag:Au/ Ag:Cu /Au:Cu/ Ag:Ni/ Ag:Al/ Ag:Pt/ Au:Al/ Au:Ni/ Au:Pt/ Al:Ni/ Al:Pt/ Ni:Pt = 50:50, Ag:Au:Cu/ Ag:Au:Al/ Ag:Au:Ni/ Ag:Au:Pt/ Au:Cu:Al/ Au:Cu:Ni/, Au:Cu:Pt/ Cu:Al:Ni/ Cu:Al:Pt/ Al:Ni:Pt = 34:33:33, or any other ratio that is known to a person skilled in the art. The metal layer 5 can have a thickness between 3 and 30 nm, preferably between 5 and 20 nm, most preferably between 5 and 15 nm.

Preferably, especially if the substrate 2 is a PET substrate, the first dielectric layer 3 and/ or the second dielectric layer 4 of a MD or DMD electrode according to the invention may be substantially composed of molybdenum-titanium-oxide/Ag/molybdenum-titanium-oxide.

Preferably, especially if the substrate 2 is a PET substrate, a polymer interlayer may be sandwiched between the first dielectric layer 3 and the substrate 2 of the optoelectronic device, if the transparent electrode is a DMD electrode, or between the metal layer 5 and the substrate 2 of the optoelectronic device, if the transparent electrode is a MD electrode.

Preferably, the metal layer 5 consists substantially of Ag or Cu and the second dielectric layer 4 consists substantially of molybdenum-titanium-oxide comprising an interfacial layer 6 in contact with the metal layer 5 and a bulk layer 7, wherein the interfacial layer 6 the molybdenum-titanium-oxide has a lower oxygen content than the bulk layer 7.

In contrast to the pure molybdenum oxide films, the MDs or DMDs 1 or 10 comprising dielectric layers 3 and/ or 4 containing Ti and/ or Ta, e.g. molybdenum-titanium-oxide, molybdenum-tantalum-oxide, and/ or molybdenum-titanium-tantalum-oxide compounds, as given above, demonstrated pronounced chemical stability in water. The oxide compound were also stable in numerous other solvents, like toluene, dimethyl-sulfoxide (DMSO), dimethylformamide (DMF) or alcohols such as isopropanol. This offers process flexibility, for example for the fabrication of perovskite solar cells, using also water-based material formulations. Moreover, they can be easily stored in ambient conditions for long time without being degraded and they can be processed with these solvents during the fabrication of optoelectronic devices such as a solar cell or a light-emitting diode (LED). Likewise, they contribute to the longevity of these devices.

For suitable concentrations of Ti or Ta in the MDs or DMDs 1 or 10, more precisely in the first and/ or second dielectric layers 3 and/ or 4, the electronic properties of the MDs or DMDs 1 and 10 are very similar to these of MoOₓ. For example, the work function of molybdenum-titanium-oxide with atomic ratios Mo:Ti≈1.85 and O:(Mo+Ti)≈2.85 is ~5 eV, which is very similar to the work function of MoOₓ with atomic ratio O:Mo≈3. Thus, MDs or DMDs 1 and 10 according to the invention have electronic properties (work function, electron affinity, ionization potential) that are similar to transparent MoOₓ, which means that they can replace the use of MoOₓ, more specifically as anode material in optoelectronic devices such as solar cells or light-emitting diodes (LEDs).

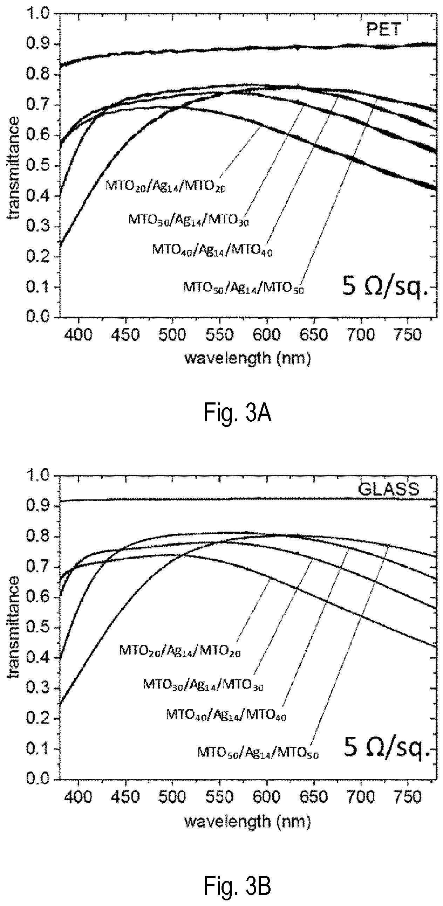

Figure 3 shows optical transmittance spectra of sputtered DMD (molybdenum-titanium-oxide/Ag/molybdenum-titanium-oxide, in the figure noted as "MTO/Ag/MTO") electrodes 10 according to the second embodiment of the invention deposited on PET (Fig. 3A) or glass-substrate (Fig. 3B) with different thicknesses of the first dielectric layer 3 and the second dielectric layer 4 and with 14 nm thick metal layers 5 of Ag. The molybdenum-titanium-oxide dielectric layers 3 and 4 were sputtered from a molybdenum-titanium-oxide target. The atomic ratios in the dielectric layers 3 and 4 were Mo:Ti≈1.85 and O:(Mo+Ti)≈2.85. The XRD characterization showed that the molybdenum-titanium-oxide dielectric layers 3 and 4 are amorphous/nanocrystalline. The reactively-sputtered (with Ar/O₂ plasma) molybdenum-titanium-oxide dielectric layers 3 and 4 are highly transparent with an indirect bandgap of ~3.2 eV. The second dielectric layer 4 comprises a first interfacial molybdenum-titanium-oxide layer 6, 10 nm in thickness, sputtered without O₂ in the plasma, and a molybdenum-titanium-oxide bulk layer 7, 30 nm in thickness, sputtered with O₂ in the plasma. The sheet resistance for all DMDs 10 is 5 Ω/sq. The maximum average visible transmittance (AVT) on PET is obtained for a MTO(40nm)/Ag(14nm)/MTO(40nm) DMD electrode 10, wherein the refractive index dispersion is extracted and used in the optical simulation to determine the thickness of the molybdenum-titanium-oxide dielectric layers 3 and 4 in the DMDs 10 that maximize the transmittance.

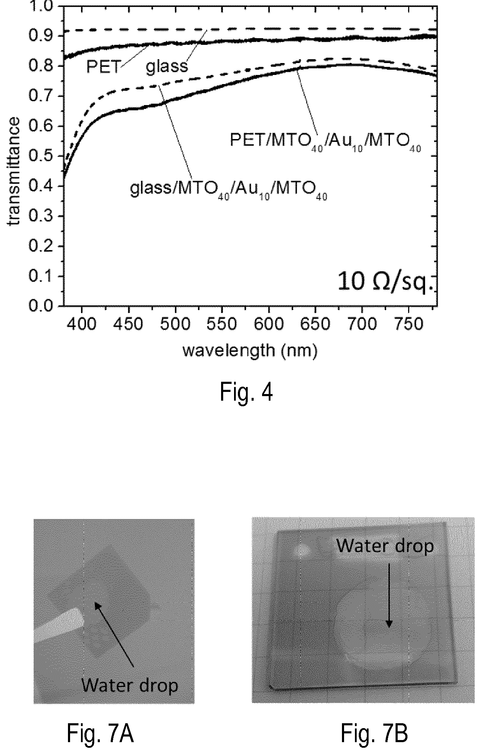

Figure 4 shows optical transmittance spectra of sputtered DMD (molybdenum-titanium-oxide/Au/molybdenum-titanium-oxide, in the figure noted as "MTO/Au/MTO") electrodes 10 according to the invention deposited on PET or glass-substrate with thicknesses of the first dielectric layer 3 and the second dielectric layer 4 of 40 nm each and with 10 nm thick metal layers 5 of Au.

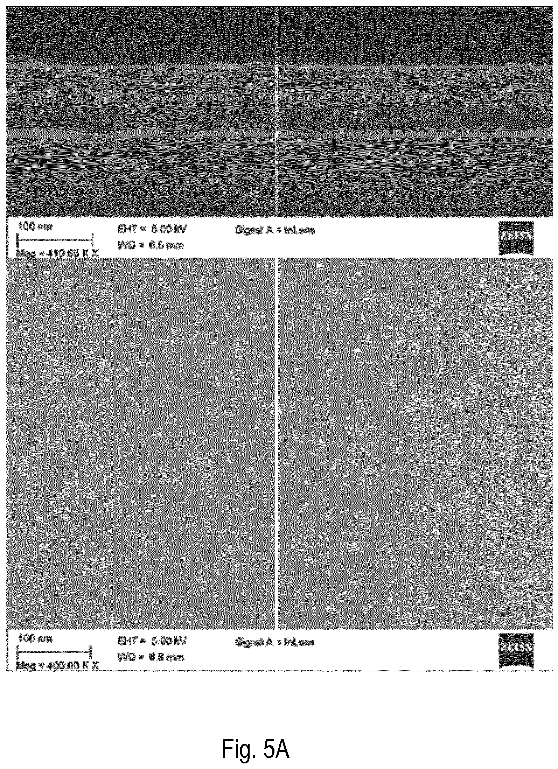

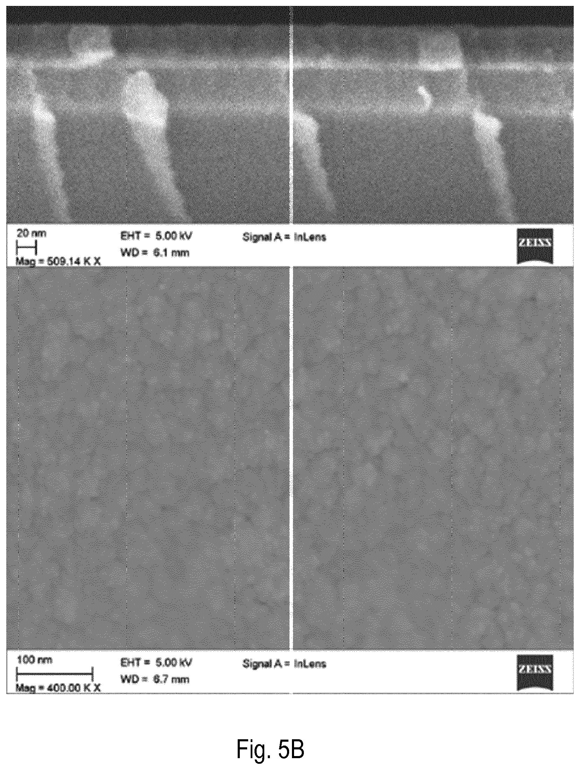

Figure 5 shows cross section and plain view Scanning Electron Microscopy (SEM) images of DMD (molybdenum-titanium-oxide/Ag/molybdenum-titanium-oxide, in the figure noted as "MTO/Ag/MTO") electrodes 10 according to the second embodiment of the invention at the as-deposited state (Fig. 5A) and after immersion in DI water for 17 hours (Fig. 5B). No morphological changes in the layers can be observed and also no changes in the resistance, which underlines the stability of the DMDs according to the invention in water. X-ray Photoelectron Spectroscopy (XPS) investigation showed that in the films the Mo is in the Mo⁶⁺, Mo⁵⁺ and Mo⁴⁺ mixed oxidation states, while the Ti is in the Ti⁴⁺ oxidation state, wherein the atomic ratios in the molybdenum-titanium-oxide dielectric layers were Mo:Ti≈2 and O:(Mo+Ti)≈3.. Ultraviolet photoelectron spectroscopy (UPS) investigation showed that the work function is 5.0-5.3 eV, which makes the molybdenum-titanium-oxide layers suitable for anodes.

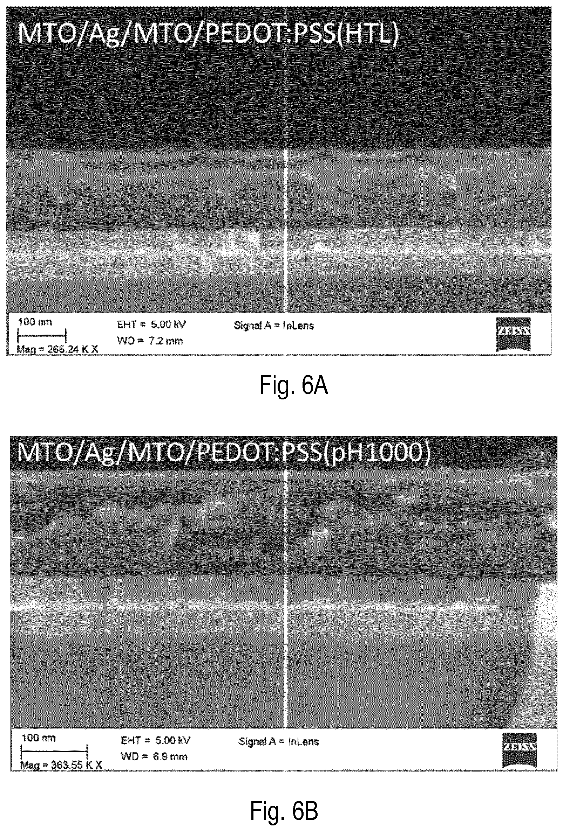

The molybdenum-titanium-oxide films are stable for processing with toluene- and water-based (Poly(3,4-ethylenedioxythiophene:Polystyrene-Sulfonate (PEDOT:PSS) formulations. Even after weeks after the deposition of PEDOT:PSS, the DMDs according to the invention present no signs of degradation (morphological or electrical), as can be seen in Figure 6. The tests were done both on glass and PET substrates with no difference.

On the contrary, the MoOₓ (x≈3) layers (without Ti or Ta) are dissolving when they are brought in contact with water, as seen in Figures 7A and 7B.

Also disclosed is a method for depositing a metal/dielectric (MD) electrode onto a substrate 2, wherein the method comprises the following steps.
A) Providing the substrate 2;
C) Depositing a metal layer 5 onto the substrate 2; and
D) Depositing a second dielectric layer 4 onto the metal layer 5.

A method for depositing a dielectric/metal/dielectric (DMD) electrode 1 or 10 onto a substrate 2 comprises the following steps.
A) Providing the substrate 2;
B) Depositing a first dielectric layer 3 onto the substrate 2;
C) Depositing a metal layer 5 onto the first dielectric layer 3; and
D) Depositing a second dielectric layer 4 onto the metal layer 5.

The MD or DMD electrode 1 or 10 can be deposited by reactive or non-reactive sputter deposition from oxide or metallic targets.

If the metal layer 5 consists substantially of silver, copper, aluminium or nickel, the method step D) preferably comprises a first sub-step and a second sub-step, wherein during the first sub-step an interfacial layer 6 of the second dielectric layer 4 is non-reactively sputter-deposited from an oxide target and wherein during the second sub-step a bulk layer 7 of the second dielectric layer 4 is reactively sputter-deposited with plasma containing oxygen from an oxide target.

Preferably, especially if the substrate 2 is a PET substrate, a polymer interlayer can be deposited between method step A) and method step B), wherein in step B) the first dielectric layer 3 is deposited onto the polymer interlayer.

A MD or DMD electrode according to the invention can be applied in an optoelectronic device comprising a substrate 2. The substrate 2 can be rigid or flexible, for example a glass, polyurethane, polyimide substrate, or a polyethylene terephthalate (PET) substrate. The optoelectronic device may comprise at least one photoactive layer, particularly a solar cell comprising a light absorbing layer or a light-emitting diode comprising a light emitting layer.

A MD or DMD electrode according to the invention can be applied in a solar cell with a perovskite light absorbing layer, e.g. methylammonium-lead-iodide, wherein, preferably, the perovskite light absorbing layer is directly deposited on the MD or DMD electrode according to the invention, followed, for example, by a layer of Phenyl-C70-butyric acid methyl ester (PCBM) and finally, for example, by an aluminium top contact. Advantageously, if using the MD or DMD electrode according to the invention, the performance of the solar cell is similar to solar cells according to the state of the art, which are based on a device stack incorporating an additional PEDOT:PSS layer between the transparent electrode according to the state of the and the perovskite light absorbing layer.

It shall be mentioned further that a MD or DMD electrode according to the invention can be applied onto windows, e.g. smart or active windows, or onto (smart) textiles, especially via a flexible substrate. Additionally, a MD or DMD electrode according to the invention can be applied in (photo-)electrochemical devices, e.g. devices for "solar-2-power"- or "solar fuels"-applications, especially in devices for water splitting and/ or for the (photo-)electrochemical CO2-reduction.

## Claims

1. A transparent conductive electrode (1, 10) comprising a metal layer (5), a second dielectric layer (4) and optionally a first dielectric layer (3), **characterized in that**
the second dielectric layer (4) and optionally also the optional first (3) dielectric layer is a molybdenum-titanium-oxide, a molybdenum-tantalum-oxide or a molybdenum-titanium-tantalum-oxide compound.

2. The transparent conductive electrode (1, 10) according to claim 1, wherein the second dielectric layer (4) is atop the metal layer (5) or the metal layer (5) is sandwiched between the first dielectric layer (3) and the second dielectric layer (4).

3. The transparent conductive electrode (1, 10) according to claim 1 or 2, wherein the second dielectric layer (4) and the first dielectric layer (3) is a molybdenum-titanium-oxide, a molybdenum-tantalum-oxide or a molybdenum-titanium-tantalum-oxide compound.

4. The transparent conductive electrode (1, 10) according to any one of claims 1 to 3, wherein the atomic concentration ratio between molybdenum and titanium, molybdenum and tantalum, and/or molybdenum and the sum of titanium and tantalum, respectively, is between 100:1 and 0.5:1, preferably between 20:1 and 2:1.

5. The transparent conductive electrode (1, 10) according to any one of claims 1 to 4, wherein the metal layer (5) consists substantially of silver, gold, copper, aluminium, nickel or platinum or alloys/ compounds of these metals.

6. The transparent conductive electrode (10) according to any one of claims 1 to 5, wherein the metal layer (5) consists substantially of silver, copper, aluminium or nickel, and wherein the second dielectric layer (4), consisting substantially of molybdenum-titanium-oxide, comprises an interfacial layer (6) comprising molybdenum-titanium-oxide in contact with the metal layer (5) and a bulk molybdenum-titanium-oxide layer (7), wherein the molybdenum-titanium-oxide interfacial layer (6) has a lower oxygen content than the molybdenum-titanium-oxide bulk layer (7).

7. The transparent conductive electrode (1, 10) according to any one of claims 1 to 6, wherein the metal layer (5) has a thickness between 3 and 30 nm, preferably between 5 and 20 nm, most preferably between 5 and 15 nm, and/ or wherein the second dielectric layer (4) and/ or the optional first dielectric layer (3) has a thickness between 5 and 100 nm, preferably between 10 and 70 nm, most preferably between 20 and 50 nm.

8. An optoelectronic device comprising a substrate (2), **characterized in that**
the optoelectronic device comprises at least one transparent conductive electrode (1, 10) according to any one of claims 1 to 7.

9. The optoelectronic device according to claim 8, comprising at least one photoactive layer, particularly a solar cell comprising a light absorbing layer or a light-emitting diode comprising a light emitting layer.

10. The optoelectronic device according to claim 8 or 9, wherein the substrate (2) is a polyethylene terephthalate substrate, and wherein the metal layer (5) consists substantially of silver and the second dielectric layer (4) and optionally first dielectric layer (3) of the transparent conductive electrode consist/s substantially of molybdenum-titanium-oxide or molybdenum-tantalum-oxide.

11. The optoelectronic device according to claim 10, wherein a polymer interlayer is sandwiched between the first dielectric layer (3) and the substrate (2) or between the metal layer (5) and the substrate (2).

12. The optoelectronic device according to claim 9, wherein the light absorbing layer is a perovskite light absorbing layer directly deposited on the transparent conductive electrode (1, 10).

13. A method for depositing a transparent conductive electrode according to any one of claims 1 to 7 onto a substrate (2), wherein the method comprises the following steps.
A) Providing a substrate (2);
B) Optionally depositing a first dielectric layer (3) onto the substrate (2);
C) Depositing a metal layer (5) onto the substrate (2); and
D) Depositing a second dielectric layer (4) onto the metal layer (5),
**characterized in that**
the second dielectric layer (4) and optionally also the optional first (3) dielectric layer is a molybdenum-titanium-oxide, a molybdenum-tantalum-oxide or a molybdenum-titanium-tantalum-oxide compound.

14. The method according to claim 13, wherein the metal layer (5) consists substantially of silver, copper, aluminium or nickel and wherein the method step D) comprises a first sub-step and a second sub-step, wherein during the first sub-step an interfacial layer (6) of the second dielectric layer (4) is non-reactively sputter-deposited from an oxide target and wherein during the second sub-step a bulk layer (7) of the second dielectric layer (4) is reactively sputter-deposited with plasma containing oxygen from an oxide target.

15. Method according to claim 13 or 14, wherein the substrate (2) is a polyethylene terephthalate substrate, wherein a polymer interlayer is deposited between method step A) and method step B) or C), wherein in step B) the first dielectric layer (3) is deposited onto the polymer interlayer or wherein in step C) the metal layer (5) is deposited onto the polymer interlayer.

## Patentansprüche

1. Eine transparente leitfähige Elektrode (1, 10) umfassend eine Metallschicht (5), eine zweite dielektrische Schicht (4) und optional eine erste dielektrische Schicht (3), **dadurch gekennzeichnet, dass**
die zweite dielektrische Schicht (4) und optional auch die optionale erste dielektrische Schicht (3) eine Molybdän-Titan-Oxid-, eine Molybdän-Tantal-Oxid- oder eine Molybdän-Titan-Tantal-Oxid-Verbindung ist.

2. Transparente leitfähige Elektrode (1, 10) nach Anspruch 1, wobei die zweite dielektrische Schicht (4) auf der Metallschicht (5) liegt oder die Metallschicht (5) zwischen der ersten dielektrischen Schicht (3) und der zweiten dielektrischen Schicht (4) angeordnet ist.

3. Transparente leitfähige Elektrode (1, 10) nach Anspruch 1 oder 2, wobei die zweite dielektrische Schicht (4) und die erste dielektrische Schicht (3) eine Molybdän-Titan-Oxid-, eine Molybdän-Tantal-Oxid- oder eine Molybdän-Titan-Tantal-Oxid-Verbindung sind.

4. Transparente leitfähige Elektrode (1, 10) nach einem der Ansprüche 1 bis 3, wobei das Atomkonzentrationsverhältnis zwischen Molybdän und Titan, Molybdän und Tantal, und/oder Molybdän und der Summe aus Titan und Tantal, jeweils zwischen 100:1 und 0,5:1, vorzugsweise zwischen 20:1 und 2:1 liegt.

5. Transparente leitfähige Elektrode (1, 10) nach einem der Ansprüche 1 bis 4, wobei die Metallschicht (5) im Wesentlichen aus Silber, Gold, Kupfer, Aluminium, Nickel oder Platin oder Legierungen/Verbindungen dieser Metalle besteht.

6. Transparente leitfähige Elektrode (10) nach einem der Ansprüche 1 bis 5, wobei die Metallschicht (5) im Wesentlichen aus Silber, Kupfer, Aluminium oder Nickel besteht und wobei die zweite dielektrische Schicht (4), bestehend im Wesentlichen aus Molybdän-Titan-Oxid, eine Grenzflächenschicht (6) umfasst, die Molybdän-Titan-Oxid in Kontakt mit der Metallschicht (5) und eine Molybdän-Titan-Oxid-Volumenschicht (7) umfasst, wobei die Molybdän-Titan-Oxid-Grenzflächenschicht (6) einen geringeren Sauerstoffgehalt als die Molybdän-Titan-Oxid-Volumenschicht (7) aufweist.

7. Transparente leitfähige Elektrode (1, 10) nach einem der Ansprüche 1 bis 6, wobei die Metallschicht (5) eine Dicke zwischen 3 und 30 nm, vorzugsweise zwischen 5 und 20 nm, am meisten bevorzugt zwischen 5 und 15 nm, aufweist und/oder wobei die zweite dielektrische Schicht (4) und/oder die optionale erste dielektrische Schicht (3) eine Dicke zwischen 5 und 100 nm, vorzugsweise zwischen 10 und 70 nm, am meisten bevorzugt zwischen 20 und 50 nm aufweist.

8. Eine optoelektronische Vorrichtung umfassend ein Substrat (2), **dadurch gekennzeichnet, dass**
die optoelektronische Vorrichtung mindestens eine transparente leitfähige Elektrode (1, 10) gemäß einem der Ansprüche 1 bis 7 umfasst.

9. Optoelektronische Vorrichtung nach Anspruch 8, umfassend mindestens eine photoaktive Schicht, insbesondere eine Solarzelle umfassend eine lichtabsorbierende Schicht oder eine lichtemittierende Diode umfassend eine lichtemittierende Schicht.

10. Optoelektronische Vorrichtung nach Anspruch 8 oder 9, wobei das Substrat (2) ein Polyethylenterephthalat-Substrat ist und wobei die Metallschicht (5) im Wesentlichen aus Silber besteht und die zweite dielektrische Schicht (4) und optional die erste dielektrische Schicht (3) der transparenten leitfähigen Elektrode im Wesentlichen aus Molybdän-Titan-Oxid oder Molybdän-Tantal-Oxid besteht(bestehen).

11. Optoelektronische Vorrichtung nach Anspruch 10, wobei eine Polymerzwischenschicht zwischen der ersten dielektrischen Schicht (3) und dem Substrat (2) oder zwischen der Metallschicht (5) und dem Substrat (2) angeordnet ist.

12. Optoelektronische Vorrichtung nach Anspruch 9, wobei die lichtabsorbierende Schicht eine Perowskit-Lichtabsorptionsschicht ist, die direkt auf die transparente leitfähige Elektrode (1, 10) aufgebracht ist.

13. Ein Verfahren zum Aufbringen einer transparenten leitfähigen Elektrode gemäß einem der Ansprüche 1 bis 7 auf ein Substrat (2), wobei das Verfahren die folgenden Schritte umfasst.
A) Bereitstellen eines Substrats (2);
B) optional Aufbringen einer ersten dielektrischen Schicht (3) auf das Substrat (2);
C) Aufbringen einer Metallschicht (5) auf das Substrat (2); und
D) Aufbringen einer zweiten dielektrischen Schicht (4) auf die Metallschicht (5),
**dadurch gekennzeichnet, dass**
die zweite dielektrische Schicht (4) und optional auch die optionale erste dielektrische Schicht (3) eine Molybdän-Titan-Oxid-, eine Molybdän-Tantal-Oxid- oder eine Molybdän-Titan-Tantal-Oxid-Verbindung ist.

14. Verfahren nach Anspruch 13, wobei die Metallschicht (5) im Wesentlichen aus Silber, Kupfer, Aluminium oder Nickel besteht und wobei der Verfahrensschritt D) einen ersten Teilschritt und einen zweiten Teilschritt umfasst, wobei während des ersten Teilschritts eine Grenzflächenschicht (6) der zweiten dielektrischen Schicht (4) nicht-reaktiv aus einem OxidTarget im Sputterverfahren aufgebracht wird und wobei während des zweiten Teilschritts eine Volumenschicht (7) der zweiten dielektrischen Schicht (4) mit sauerstoffhaltigem Plasma aus einem Oxidtarget reaktiv im Sputterverfahren aufgebracht wird.

15. Verfahren nach Anspruch 13 oder 14, wobei das Substrat (2) ein Polyethylenterephthalat-Substrat ist, wobei zwischen Verfahrensschritt A) und Verfahrensschritt B) oder C) eine Polymerzwischenschicht aufgebracht wird, wobei in Schritt B) die erste dielektrische Schicht (3) auf die Polymerzwischenschicht aufgebracht wird oder wobei in Schritt C) die Metallschicht (5) auf die Polymerzwischenschicht aufgebracht wird.

## Revendications

1. Électrode conductrice transparente (1, 10) comprenant une couche métallique (5), une deuxième couche diélectrique (4) et éventuellement une première couche diélectrique (3), **caractérisée en ce que** la deuxième couche diélectrique (4) et, éventuellement, aussi la première (3) couche diélectrique optionnelle sont composés d'oxyde de molybdène-titane, d'oxyde de molybdène-tantale ou d'oxyde de molybdène-titane-tantale.

2. Électrode conductrice transparente (1, 10) selon la revendication 1, dans laquelle la deuxième couche diélectrique (4) est placée au-dessus de la couche métallique (5) ou la couche métallique (5) est prise en sandwich entre la première couche diélectrique (3) et la deuxième couche diélectrique (4).

3. Électrode conductrice transparente (1, 10) selon la revendication 1 ou 2, dans laquelle la deuxième couche diélectrique (4) et la première couche diélectrique (3) sont composés d'oxyde de molybdène-titane, d'oxyde de molybdène-tantale ou d'oxyde de molybdène-titane-tantale.

4. Électrode conductrice transparente (1, 10) selon l'une quelconque des revendications 1 à 3, dans laquelle le rapport de concentration atomique entre le molybdène et le titane, le molybdène et le tantale, et/ou le molybdène et la somme du titane et du tantale, respectivement, est compris entre 100:1 et 0,5:1, de préférence entre 20:1 et 2:1.

5. Électrode conductrice transparente (1, 10) selon l'une quelconque des revendications 1 à 4, dans laquelle la couche métallique (5) est constituée essentiellement d'argent, d'or, de cuivre, d'aluminium, de nickel ou de platine, ou d'alliages/composés de ces métaux.

6. Électrode conductrice transparente (10) selon l'une quelconque des revendications 1 à 5, dans laquelle la couche métallique (5) est constituée essentiellement d'argent, de cuivre, d'aluminium ou de nickel, et dans laquelle la deuxième couche diélectrique (4), constituée essentiellement d'oxyde de molybdène-titane, comprend une couche interfaciale (6) comprenant d'oxyde de molybdène-titane en contact avec la couche métallique (5) et une couche massive d'oxyde de molybdène-titane (7), dans laquelle la couche interfaciale d'oxyde de molybdène-titane (6) présentant une teneur en oxygène inférieure à celle de la couche massive d'oxyde de molybdène-titane (7).

7. Électrode conductrice transparente (1, 10) selon l'une quelconque des revendications 1 à 6, dans laquelle la couche métallique (5) présente une épaisseur comprise entre 3 et 30 nm, de préférence entre 5 et 20 nm, plus préférablement entre 5 et 15 nm, et/ou dans laquelle la deuxième couche diélectrique (4) et/ou la première couche diélectrique optionnelle (3) présentent une épaisseur comprise entre 5 et 100 nm, de préférence entre 10 et 70 nm, plus préférablement entre 20 et 50 nm.

8. Dispositif optoélectronique comprenant un substrat (2), **caractérisé en ce que** le dispositif optoélectronique comprend au moins une électrode conductrice transparente (1, 10) selon l'une quelconque des revendications 1 à 7.

9. Dispositif optoélectronique selon la revendication 8, comprenant au moins une couche photoactive, notamment une cellule solaire comprenant une couche absorbant la lumière ou une diode électroluminescente comprenant une couche émettant de la lumière.

10. Dispositif optoélectronique selon la revendication 8 ou 9, dans lequel le substrat (2) est un substrat en polyéthylène téréphtalate, et dans lequel la couche métallique (5) est constituée essentiellement d'argent et la deuxième couche diélectrique (4) et, éventuellement, la première couche diélectrique (3) de l'électrode conductrice transparente sontconstituées essentiellement d'oxyde de molybdène-titane ou d'oxyde de molybdène-tantale.

11. Dispositif optoélectronique selon la revendication 10, dans lequel une intercouche de polymère est prise en sandwich entre la première couche diélectrique (3) et le substrat (2) ou entre la couche métallique (5) et le substrat (2).

12. Dispositif optoélectronique selon la revendication 9, dans lequel la couche absorbant la lumière est une couche de pérovskite absorbant la lumière déposée directement sur l'électrode conductrice transparente (1, 10).

13. Procédé pour déposer une électrode conductrice transparente selon l'une quelconque des revendications 1 à 7 sur un substrat (2), le procédé comprenant les étapes suivantes:
A) fournir un substrat (2);
B) éventuellement déposer une première couche diélectrique (3) sur le substrat (2);
C) déposer une couche métallique (5) sur le substrat (2); et
D) déposer une deuxième couche diélectrique (4) sur la couche métallique (5);
**caractérisé en ce que**
la deuxième couche diélectrique (4) et, éventuellement, aussi la première (3) couche diélectrique optionnelle sont composés d'oxyde de molybdène-titane, d'oxyde de molybdène-tantale ou d'oxyde de molybdène-titane-tantale.

14. Procédé selon la revendication 13, dans lequel la couche métallique (5) est constituée essentiellement d'argent, de cuivre, d'aluminium ou de nickel et dans lequel l'étape D) du procédé comprend une première sous-étape et une deuxième sous-étape, une couche interfaciale (6) de la deuxième couche diélectrique (4) étant déposée par pulvérisation cathodique de manière non réactive à partir d'une cible d'oxyde lors de la première sous-étape, et une couche massive (7) de la deuxième couche diélectrique (4) étant déposée par pulvérisation cathodique de manière réactive à l'aide d'un plasma contenant de l'oxygène provenant d'une cible d'oxyde lors de la deuxième sous-étape.

15. Procédé selon la revendication 13 ou 14, dans lequel le substrat (2) est un substrat en polyéthylène téréphtalate, dans lequel une intercouche de polymère est déposée entre l'étape A) du procédé et l'étape B) ou C) du procédé, la première couche diélectrique (3) étant déposée sur la intercouche de polymère lors de l'étape B), ou la couche métallique (5) étant déposée sur la intercouche de polymère lors de l'étape C).
